## Europäisches Patentamt
## European Patent Office
## Office européen des brevets

(19)

(11) Publication number: **0 040 640**
**A1**

(12) **EUROPEAN PATENT APPLICATION**
published in accordance with Art. 158(3) EPC

(21) Application number: 80902300.5

(22) Date of filing: 26.11.80

Data of the international appli-
cation taken as a basis:

(86) International application number:
**PCT/JP 80/00288**

(87) International publication number:
**WO 81/01630 (11.06.81 81/14)**

(51) Int. Cl.³: **H 01 L 43/06**

(30) Priority: **29.11.79 JP 154662/79**

(43) Date of publication of application: **02.12.81**
**Bulletin 81/48**

(84) Designated Contracting States: **DE FR GB NL**

(71) Applicant: **SONY CORPORATION,**
**7-35 Kitashinagawa 6-Chome Shinagawa-ku,**
**Tokyo 141 (JP)**

(72) Inventor: **TAKEHANA, Yoshito, 5328 Seyamachi Seya-ku**
**Yokohama-shi, Kanagawa-ken 246 (JP)**
Inventor: **MIYAUCHI, Kazuo, 161 Motomachi 4-chome**
**Naka-ku Yokohama-shi, Kanagawa-ken 231 (JP)**

(74) Representative: **Thomas, Christopher Hugo et al, D**
**Young & Co 10 Staple Inn, London WC1V 7RD (GB)**

(54) **MAGNETICALLY SENSITIVE SEMICONDUCTOR DEVICE.**

(57) A magnetically sensitive semiconductor device for
producing a Hall-voltage output in the presence of a mag-
netic field. A carrier, which has been injected from the
junction between first and second semiconductor regions,
is accelerated by means of an electric field in a depletion
layer located at the junction between second and third
semiconductor regions. The arrangement is such that,
owing to the high speed of the carrier, a higher Hall output
voltage can be obtained even for comparatively small elec-
tric currents.

S P E C I F I C A T I O N

Title of Invention

   magneto-sensitive semiconductor device

TECHNICAL FIELD

        The present invention relates to a
magneto-sensitive semiconductor device utilizing the
Hall effect.

BACKGROUND ART

        In a prior art Hall element, a Hall
voltage $V_H$ expressed by the following equation is generated.

$$V_H = \frac{I \cdot B}{q \cdot n \cdot d} \qquad ----- (1)$$

(where I is input current, B is magnetic flux density
component perpendicular to the input current, q is carrier
charge, n is carrier concentration, and d is the distance
where magnetic field acts i.e. the thickness of a semiconductor substrate).    This Hall voltage is caused
by Lorentz force $F$ acting on the carriers moving in the
magnetic field.

$$F = q(E+v \times B) \qquad ----- (2)$$

(where E is the electric field which moves the carrier and
v is carrier velocity).    Being the X-axis component of
the carrier velocity  v and the Z-axis component of the
magnetic flux density B are taken, electric field Ey
along the y-axis is generated.

$$Ey = v_x \cdot B_z \qquad ----- (3)$$

        W being the distance along which Ey is
generated (the width of the substrate), the Hall voltage
$V_H$ is expressed as follows:

$$V_H = E_y \cdot W \qquad ----- (4)$$

since

$I_x = J_x \cdot W_d$, substituting $v = \mu E$ and $J = \sigma E$ (where $\mu$ is

carrier mobility, $J$ is current density, and $\sigma$ is conductivity),

then $V_H = \mu \cdot W \cdot E_x \cdot B_z$ $\qquad$ ----- (5a)

$$= \frac{\mu \cdot B_z \cdot I_x}{d \cdot \sigma} \qquad \text{----- (5b)}$$

the equation (1) is obtained, substituting $\sigma = q \cdot \mu \cdot n$

in the equation (5b).

In order to increase the Hall voltage,
magnetic flux density and the width, being equal the
electric field and the carrier mobility—the carrier
mobility increases as the electric field increases but
is gradually saturated — must increase from equation (5a).
With the conventional Hall element, in which the conduction
mechanism by the majority carrier has the linear current
voltage characteristic, the current increases in proportion to the input voltage in order to increase the
electric field. This is clear from the equation (1).
It is not practical to get the carrier mobility close to
the saturation velocity because of requiring large current.

DISCLOSURE OF INVENTION

This invention is to obtain higher Hall
voltage or magnetic sensitivity than the conventional
device. With the magneto-sensitive device according
to this invention, the magnetic sensitivity increases
by about three power ($10^3$) because of large carrier velocity
and the device can be utilized for highly sensitive
measurement, switch head and so on.

According to this invention, the carriers
run in the depletion layer of the reversely biased junction,
which are injected from the near junction which is forwardly
biased. The carrier velocity is determined by the voltage across the reversely biased junction and the carrier current density is determined by the voltage across the forwardly biased junction, either independently. Accordingly, the carrier velocity can increase close to the saturation velocity in the depletion layer without increasing the current.

BRIEF DESCRIPTION OF THE DRAWINGS

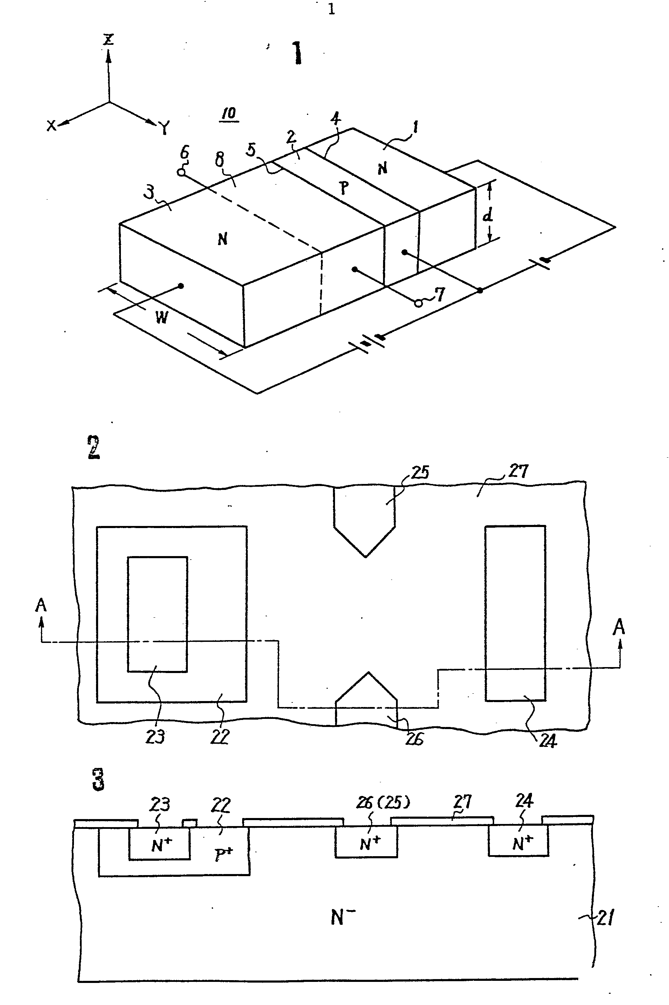

Fig. 1 is a perspective view showing the diagramatical structure of this invention, and Figs. 2 and 3 are a plan view of an embodiment of the magneto-sensitive semiconductor device according to the invention and a cross-sectional view on the A-A line respectively.

BEST MODE FOR CARRYING OUT THE INVENTION

Fig. 1 diagramatically shows first, second and third regions 1, 2 and 3 of N, P and N types, respectively. There are provided a voltage supply source applying a forward bias voltage to a first PN-junction 4 between the first and second regions 1 and 2, and a voltage supply source applying a reverse bias voltage to a second PN-junction 5 between the second and third regions 2 and 3. A transistor 10 is constructed which has emitter, base and collector made of the first, second and third regions 1, 2 and 3, respectively, and in which the carriers move from the emitter 1 to the collector 3 (in X-axis direction). The Z-axis component of magnetic field applied to the transistor (along the thickness d of the substrate is sensed. The Hall voltage is induced along width W of the substrate (Y-axis direction) and output electrodes 6 and 7 are provided at the both sides of a depletion layer region 8 of the second junction 5.

Electrons in the emitter region 1 are injected through the forwardly biased emitter-base junction 4 into the base region 2 and reach the depletion layer 8 as the base width in the X-axis direction is sufficiently smaller than the diffusion length of the electron. The electrons are accelerated therein by the collector -base voltage up to its saturation velocity and reach the collector region 3.      Since the magnitude of the electric field applied to the reversely biased junction can be very large as compared without junction, the carrier velocity can be readily close to its saturation velocity.      While the electron current density through the depletion layer 8 is determined by the emitter-base voltage, this voltage need not be increased so as to get large electron velocity. That is, controlling the carrier velocity is indepent from controlling the carrier current density.

The Hall electric field is generated along the y-axis when the z-axis component of the magnetic flux density acts on the space charge region carriers running in the x-direction.      The output electrodes 6 and 7 are provided to face the depletion layer region 8 of the collector-base junction 5.      The collector region 3 must have such low impurity concentration that the depletion layer should readily extend, and the collector-base voltage must be such a value that the depletion layer should reach the output electrodes 6 and 7.      When the carrier velocity is close to the saturation velocity, the carrier mobility and hence the Hall voltage are little influenced by tem-perature.

Referring to Figs. 2 and 3 an embodiment of this invention will be explained.    An N-type silicon substrate 21 of 300μ  thickness and 40 Ωcm resistivity is provided as a collector region and p-type base and N-type emitter regions 22 and 23 are formed by double diffusion.    An $N^+$-type collector region 24 is diffused distant from the base by 24 μ.    At just between the base and collector $N^+$ regions 22 and 24 formed are two $N^+$-type output regions 25 and 26, which are apart from each other by 12 μ .    All the above regions are formed on one major surface of the substrate 21, and the emitter, collector $N^+$ and output regions 23, 24, 25 and 26 are diffused at the same time.    Emitter, base, collector and output regions are provided with electrodes, respectively, and the surface of the substrate is passivated by an $SiO_2$ layer 27.

The output regions 25 and 26 may be formed of $P^+$-type to be a diode structure in place of two ohmic $N^+$-regions.    There may be a pair of diodes in parallel and opposite polarity, to which suitable biasings are applied to controll the output level.

The magneto-sensitive device may be formed not only in a silicon substrate but also in a silicon epitaxial layer on an insulating crystalline substrate made of sapphire  or the like, in which the thickness d of the current path can be small and the width W is selected by etching pattern of the silicon layer with plural devices on the same substrate.    Further, the device may be formed in germanium a III-V compound semiconductor of higher carrier mobility such as Ga As.

The running carriers in the space charge region in solid are contrasted to electrons in vacuum, in which, the electrons run from a cathode to a plate in a

-5-

vacuum tube and the Hall voltage is derived from a pair of output electrodes provide between the cathode and the plate.

The alrge velocity of the carrier running in the space charge depletion region of semiconductor can be utilized for other than the Hall effect field. For example, a $P^+$-type gate region of a mesh or grid shape may be formed in the depletion layer region 8 in palce of the output electordes 6 and 7, shown in Fig. 1, by which the carriers passing through the channel defined thereby, are used for the input of amplification. In this case, a fixed forward voltage is applied across the emitter-base, an input signal is applied across the gate-base or gate-emitter, and a voltage supply source and a load, in series, are connected between the collector-base or collector-emitter. The large carrier velocity running through the channel renders, the transistor showing high frequency characteristic and transconductance.

CLAIM

A magneto-sensitive semiconductor device, characterized in that said device comprises a first semiconductor region of a first conductivity type, a second semiconductor region of a second conductivity·type, a third semiconductor region of the first conductivity type, means for applying a forward bias across a first junction between said first and second regions, means for applying a reverse bias across a second junction between said second and third regions, and a pair of output electrodes provided in opposed relation and facing a depletion layer extended from said second junction reversely biased.

0040640

(1) is a first region of an N-type conductivity, (2) is a second region of a P-type conductivity, (3) is a third region of the N-type conductivity, (4) is a first PN-junction, (5) is a second PN-junction, (6) and (7) are respecitvely output electrodes, (8) is a depletion layer region, (21) is a silicon substrate, (22) is a base region of a P-type, (23) is an emitter region of an N-type, (24) is a collector region of an $N^+$-type, (25) and (26) are respectively output regions of an $N^+$-type, and (27) is an $SiO_2$ layer.

0040640

Fig. 1

Fig. 2

Fig. 3

0040640

# INTERNATIONAL SEARCH REPORT

International Application No  PCT/JP80/00288

**I. CLASSIFICATION OF SUBJECT MATTER** (if several classification symbols apply, indicate all) [3]

According to International Patent Classification (IPC) or to both National Classification and IPC

Int. Cl.[3]  H01L43/06

**II. FIELDS SEARCHED**

| Minimum Documentation Searched [4] | |
|---|---|
| Classification System | Classification Symbols |
| I P C | H01L43/06 |

Documentation Searched other than Minimum Documentation
to the Extent that such Documents are Included in the Fields Searched [5]

—

**III. DOCUMENTS CONSIDERED TO BE RELEVANT [14]**

| Category [*] | Citation of Document, [16] with indication, where appropriate, of the relevant passages [17] | Relevant to Claim No. [18] |
|---|---|---|
| A | US, A, 3,585,462    1971-6-15<br><br>Sprague Electric Co. | 1 |
| A | US, A, 3,614,556    1971-10-19<br><br>Tokyo Shibaura Electric Co., Ltd. | 1 |

* Special categories of cited documents: [15]

"A" document defining the general state of the art
"E" earlier document but published on or after the international filing date
"L" document cited for special reason other than those referred to in the other categories
"O" document referring to an oral disclosure, use, exhibition or other means

"P" document published prior to the international filing date but on or after the priority date claimed
"T" later document published on or after the international filing date or priority date and not in conflict with the application, but cited to understand the principle or theory underlying the invention
"X" document of particular relevance

**IV. CERTIFICATION**

| Date of the Actual Completion of the International Search [3] | Date of Mailing of this International Search Report [3] |
|---|---|
| February 20, 1981 (20.2.81) | March 9, 1981 (09.03.81) |
| International Searching Authority [1] | Signature of Authorized Officer [20] |
| Japanese Patent Office | |

Form PCT/ISA/210 (second sheet) (October 1977)